# EUROPÄISCHE PATENTANMELDUNG

(11) **EP 0 732 792 A2**
(43) Veröffentlichungstag der Anmeldung: **18.09.1996**
(21) Anmeldenummer: 96250056.7
(22) Anmeldetag: 08.03.1996
(51) Int. Cl.: H02H 3/13, H02H 5/12

(54) **Berührungsschutzschaltung für zwei auf einen gemeinsamen Verbraucher geschaltete Starkstrom-Versorgungsleitungen**

(30) Priorität: 14.03.1995 DE 19510693
(71) Anmelder: MANNESMANN Aktiengesellschaft, D-40213 Düsseldorf (DE)
(72) Erfinder: Kruschinski, Andreas, 40476 Düsseldorf (DE)
(74) Vertreter: Meissner, Peter E., Dipl.-Ing.

(57) **Zusammenfassung**

Die Erfindung betrifft eine Berührungsschutzschaltung an der Mehrphasen-Stromversorgung eines Hafenmobilkranes oder dgl. nach dem Trennen einer von zwei auf einen gemeinsamen Verbraucher geschalteten, über je eine Steckverbindung mit externen Einspeisestellen verbundenen Versorgungsleitung von einer der Einspeisestellen.
Hierbei ist der Strom in beiden Versorgungsleitungen über Meßstromwandler (3, 4) erfaßbar und in einer Auswerteelektronik (8) mit einem vorgegebenen Grenzwert vergleichbar, bei dessen Unterschreitung die Versorgungsleitungen zwischen Einspeisestelle (1, 2) und Verbraucher (10) abschaltbar sind.

## Beschreibung

Die Erfindung betrifft eine Berührungsschutzschaltung an der Mehrphasen-Stromversorgung eines Hafenmobilkranes oder dergl. Großgerät nach demTrennen einer von mindestens zwei auf einen gemeinsamen Verbraucher geschalteten, über je eine Steckverbindung mit externen Einspeisestellen verbundene Versorgungsleitungen von einer der Einspeisestellen.

Hafenmobilkrane werden häufig diesel-elektrisch betrieben. Alle Antriebe und Kontrollsysteme arbeiten elektrisch, die erforderliche elektrische Energie wird von Generatoren erzeugt, die ihrerseits von den Dieselaggregaten des Gerätes angetrieben sind. Dieses Antriebssystem macht den Hafenmobilkran bei niedrigen Betriebskosten unbhängig von der Elektroversorgung des jeweiligen Standortes.

Zur größeren Flexibilität und unabhängig von der vorstehend beschriebenen Energieversorgung sind die Hafenmobilkrane häufig auch unmittelbar -d.h. unter Verzicht auf die dieselbetriebenen Generatoren- elektrisch zu betreiben, wobei die elektrische Energie von einer externen Stromquelle zugeführt wird. Diese Betriebsweise des Kranes minimiert die Betriebskosten und ist umweltverträglicher, weil die Maschinen weniger Geräusche verursachen und keine Abgase entstehen. Auch sind die reinen Elektroantriebe störunempfindlicher und wartungsärmer als Dieselmotoren.

Zur Elektroversorgung von Hafenmobilkranen sind In den meisten Hafenanlagen in gleichmäßigen Abständen am Kai verteilt Einspeisestellen vorhanden, an denen mittels Steckverbindungen elektrischer Strom angezapft werden kann. Die Hafenmobilkrane sind zu diesem Zweck mit Stromkabeln von 50 bis 400 m Länge ausgerüstet, je nachdem wie hoch die zur Verfügung stehende Spannung ist. Spannungen von 6000 Volt sind keine Seltenheit.

In vielen Häfen sind am Kai noch alte Steckverbindungen installiert, die in ihren Anschlußleistungen aufgrund ihrer Bauart begrenzt sind. In einem solchen Fall ist es üblich, größere Anschlußleistungen dadurch zu erreichen, daß der Strom über zwei Starkstrom-Versorgungsleitungen eingespeist wird, wobei beide Versorgungsleitungen auf den gemeinsamen Verbraucher geschaltet werden.

Bei dieser Art der parallelen Einspeisung ergibt sich ein gefährliches Problem, das darin besteht, daß beim Trennen einer der Steckverbindungen von einer der Einspeisestellen an den Stiften dieser gelösten Steckverbindung eine gefährliche Spannung anliegt, die über das Gerät von der anderen noch gesteckten Einspeisestellen zugeführt wird. Die Berührung der Stifte der getrennten Steckverbindung ist lebensgefährlich, solange die zweite Steckverbindung nicht ebenfalls von der Einspeisestelle getrennt ist. Es ist zwar bekannt, die Steckverbindungen mit separaten Ausschaltern zu versehen, doch werden diese Schalter häufig nicht betätigt.

Ausgehend von einem Hafenmobilkran oder dergleichn Großgerät mit mindestens zwei auf einen gemeinsamen Verbraucher geschalteten Starkstrom-Versorgungsleitungen liegt der vorliegenden Erfindung die Aufgabe zugrunde, zum Schutz des Bedienungspersonals die gefährlichen Berührungsströme automatisch abzuschalten, wenn eine der Steckverbindungen von ihrer Einspeisestelle getrennt wird.

Zur Lösung der Aufgabe wird erfindungsgemäß eine Schaltung vorgeschlagen, die dadurch gekennzeichnet ist, daß der Strom in beiden Versorgungsleitungen über Meßstromwandler erfaßbart und -über einen Widerstand geleitet- in einer Auswerteelektronik mit einem vorgegebenen Grenzwert vergleichbar ist, bei dessen Unterschreitung die Versorgungsleitungen zwischen Einspeisestelle und Verbraucher abschaltbar sind.

Erfindungsgemäß arbeitet die Berührungsschutzschaltung in der Art einer Phasenvergleichsschutzschaltung, mit der in einem elektrischen Mehrphasensystem der Ausfall einer oder mehrerer Phasen detektiert werden kann. Bei einem gattungsgemäßen System, bei dem zwei Versorgungsleitungen mit jeweils mehreren Phasen vorliegen, wird jeweils eine unterschiedliche Phasen in jeder Versorgungsleitung hinsichtlich des in ihnen fließenden Stromes untersucht und dann, wenn infolge des Ziehens einer der Steckverbindungen ein bestimmter vorgegebener Grenzwert unterschritten wird, werden beide Versorgungsleitungen unterbrochen.

Die Berührungsschutzschaltung nach Anspruch 2 ist in einer Ausgestaltung der Erfindung dadurch gekennzeichnet, daß jede Versorgungsleitung mit einem Trennschalter zum Unterbrechen des Verbraucherstromflusses versehen ist, daß in jeder Versorgungsleitung zwischen Steckverbindung und Trennschalter in unterschiedlichen Phasen mindestens ein Meßstromwandler vorgesehen ist, deren Ausgangsströme in der gemeinsamen Auswerteelektronik zu einem Signal zum gleichzeitigen Betätigen der Trennschalter zum Unterbrechen aller Phasen der Versorgungsleitungen verwertbar sind und daß parallel zum Verbraucher hinter den Meßstromwandlern und vor den Trennschaltern ein den zu überwachenden Strom verursachender Widerstand zwischen die entsprechenden Phasen der Versorgungsleitungen geschaltet ist.

Mit der erfindungsgemäßen Berührungsschutzschaltung wird sichergestellt, daß nach Trennen einer Steckverbindung von einer der Einspeisestellen über die Auswerteelektronik der ungleiche Stromfluß durch die Meßwandler unmittelbar erfaßt wird, und die Auswerteelektronik ein Signal an die Trennschalter zur Unterbrechung der Versorgungsleitungen gibt. Der Widerstand verursacht das fließen eines Stromes, der benötigt wird, um der Auswerteelektronik den notwendigen Schaltstrom zu liefern.

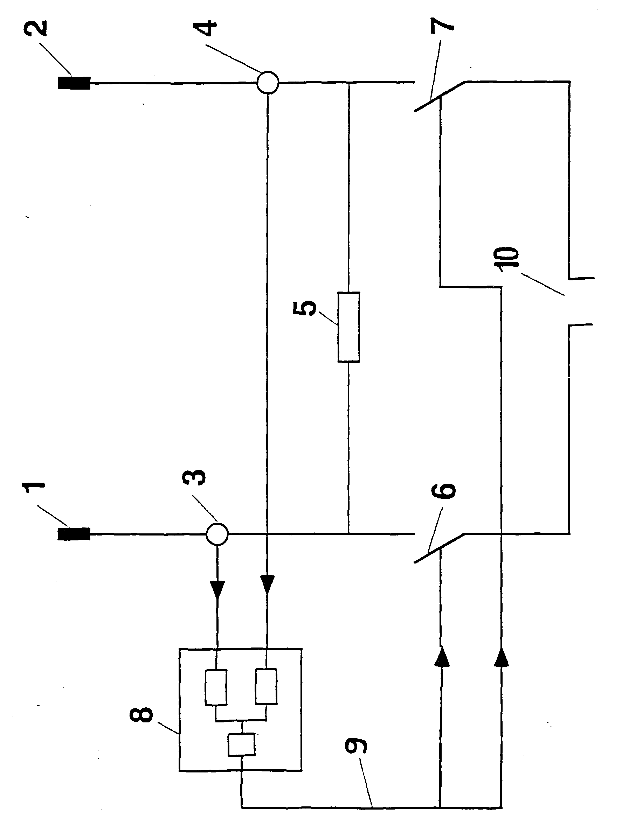

Ein Ausführungsbeispiel der Erfindung in der Zeichnung dargestellt und wird nachfolgend beschrieben:

Mit 1 und 2 sind zwei mehrpolige Steckverbindungen bezeichnet, wobei im dargestellten Schaltplan angenommen sei, daß bei 1 und 2 jeweils eine unterschiedliche Phase jeder der beiden Starkstrom-Versorgungsleitungen durch die Meßstromwandler 3 und 4 geführt sind, die den zu überwachenden Meßstrom von ca.1 Amper transformieren. Die Meßstromwandler 3 und 4 sind unmittelbar mit einer Auswerteelektronik 8 verbunden, in der die von den Meßstromwandlern 3 und 4 gelieferten Meßströme mit einem vorgegebenen Grenzwert verglichen werden.

Sind die von den Meßstromwandlern 3 und 4 an die Auswerteelektronik gelieferten Meßströme gleich, so wird über den Grenzwertmelder ein Freigabesignal 9 an die Schalter 6 und 7 gegeben, das diese einschaltet. Das Gerät wird von den Einspeisestellen 1 und 2 über die parallel aufliegenden Versorgungsleitungen 10 betrieben.

Sobald einer der Steckverbindungen 1 oder 2 von der Einspeisestelle getrennt wird, detektiert die Auswerteelektronik unterschiedliche Ströme. Das Signal 9 fehlt und die Schalter 6 und 7 werden sofort ausgeschaltet, deshalb liegt die gefährliche Berührungsspannung an den Stiften der gezogenen Steckverbindungt nicht mehr an.

## Patentansprüche

1. Berührungsschutzschaltung an der Mehrphasen-Stromversorgung eines Hafenmobilkranes oder dergl. Großgerät nach demTrennen einer von zwei auf einen gemeinsamen Verbraucher geschalteten, über je eine Steckverbindung mit externen Einspeisestellen verbundene Versorgungsleitungen von einer der Einspeisestellen,
dadurch gekennzeichnet,
daß der Strom in beiden Versorgungsleitungen über Meßstromwandler (3,4) erfaßbart und -über einen Widerstand (5) geleitet- in einer Auswerteelektronik (8) mit einem vorgegebenen Grenzwert vergleichbar ist, bei dessen Unterschreitung die Versorgungsleitungen zwischen Einspeisestelle (1,2) und Verbraucher (10) abschaltbar sind.

2. Berührungsschutzschaltung nach Anspruch 1,
dadurch gekennzeichnet,
daß jede Versorgungsleitung mit einem Trennschalter (6,7) zum Unterbrechen des Verbraucherstromflusses versehen ist,
daß in jeder Versorgungsleitung zwischen Steckverbindung (1,2) und Trennschalter (6.7) in unterschiedlichen Phasen mindestens ein Meßstromwandler (3,4) vorgesehen ist, deren Ausgangsströme in der gemeinsamen Auswerteelektronik (8) zu einem Signal zum gleichzeitigen Betätigen der Trennschalter (6,7) zum Unterbrechen aller Phasen der Versorgungsleitungen verwertbar sind und
daß parallel zum Verbraucher (10) hinter den Meßstromwandlern (3,4) und vor den Trennschaltern (6,7) ein den zu überwachenden Strom verursachender Widerstand (5) zwischen die entsprechenden Phasen der Versorgungsleitungen geschaltet ist.
